# EUROPÄISCHE PATENTSCHRIFT

(11) **EP 3 717 880 B1**
(45) Veröffentlichungstag und Bekanntmachung des Hinweises auf die Patenterteilung: **08.12.2021**
(21) Anmeldenummer: 18768854.4
(22) Anmeldetag: 10.09.2018
(51) Int. Cl.: G01L 1/22, G01B 7/16

(54) **FLEXIBLES PRODUKT**
FLEXIBLE PRODUCT
PRODUIT FLEXIBLE

(30) Priorität: 30.11.2017 DE 102017221544
(43) Veröffentlichungstag der Anmeldung: 07.10.2020
(73) Patentinhaber: Benecke-Kaliko AG, 30419 Hannover (DE)
(72) Erfinder: HUBER, Tobias, 30419 Hannover (DE); SENNE, Armin, 30419 Hannover (DE); WEIGERT, Christian, 30419 Hannover (DE)
(74) Vertreter: Continental Corporation
(86) Internationale Anmeldenummer: PCT/EP2018/074270
(87) Internationale Veröffentlichungsnummer: WO 2019/105622

(56) Entgegenhaltungen:
- WO-A2-2013/044226

## Beschreibung

Die vorliegende Erfindung betrifft ein flexibles Produkt gemäß dem Oberbegriff des Patentanspruchs 1 sowie ein Verfahren zur Herstellung eines derartigen flexiblen Produkts gemäß des Patentanspruchs 10.

Auf vielen technischen Gebieten wächst das Bedürfnis, Sensoren oder sensorische Fähigkeiten in Produkte zu integrieren, um mehr Informationen über die Produkte während der Produktion und bzw. oder während der Nutzung zu erhalten. Aus diesen Informationen können Rückschlüsse zur Verbesserung zukünftiger Produktgenerationen bzw. zur Entwicklung neuer Produkte gezogen werden. Auch können z.B. die Haltbarkeit, der Verschleiß, die Belastung und dergleichen während der Nutzung erfasst werden, so dass eine rechtzeitige Wartung belastungsabhängig geplant bzw. ein Produkt rechtzeitig vor dem Versagen aus dem Verkehr gezogen und ggfs. ersetzt werden kann.

Dies soll zunehmend auch für Produkte aus flexiblen Materialien wie z.B. für elastische Produkte z.B. aus Gummi wie z.B. Reifen, Förderbänder, Luftfedern, Antriebsriemen, Schläuche und dergleichen ermöglicht werden.

Beispielsweise werden zunehmend Sensoren in z.B. Förderbänder integriert, um z.B. Beschädigungen wie insbesondere Risse in Längsrichtung erkennen zu können. Hierzu sind seit Längerem Leiterschleifen bekannt, welche aus metallischen Litzen bestehen, welche in dem Körper des Förderbands einvulkanisiert sind. Die Leiterschleifen werden üblicherweise durch elektromagnetische Felder von außerhalb auf ihre Integrität überprüft. Lässt sich eine Leiterschleife nicht mehr detektieren, kann auf eine Beschädigung des Förderbandes in diesem Bereich geschlossen und das Förderband ggfs. angehalten werden.

Nachteilig ist hierbei, dass über derartige Leiterschleifen zwar eine einfache Detektion von Beschädigungen umgesetzt werden kann, jedoch keine sonstigen Informationen aus dem Produkt bzw. über das Produkt gewonnen werden können.

Alternativ werden daher auch Transponder in Förderbändern eingesetzt, welche auf einer Platine ausgebildet sind und üblicherweise eine (Fernfeld-)Antenne z.B. aus Glasfasergewebe aufweisen. Zusätzlich können z.B. Sensoren, Spannungsquellen und dergleichen mit dem Transponder verbunden sein. Auch die Transponder werden zusammen mit ihrer Antenne und ggfs. mit weiteren Komponenten im Körper des Förderbands einvulkanisiert.

Vergleichbare Anwendungen bzw. Bestrebungen gibt es auch für andere Elastomerprodukte wie z.B. Reifen, Luftfedern, Antriebsriemen, Schläuche und dergleichen, um möglichst viele Informationen wie z.B. Druck, Temperatur, mechanische Spannungen und dergleichen möglichst kontinuierlich in bzw. an dem Produkt erfassen zu können. Die erfassten Informationen sollen dabei vorzugsweise drahtlos nach außerhalb übertragen werden können.

Nachteilig ist hierbei, dass zu diesem Zweck entsprechend funktionsreiche Sensoren bzw. Sensorschaltungen in das Produkt eingebracht bzw. auf das Produkt aufgebracht werden müssen, welche diese Informationen auch erfassen und vorzugsweise drahtlos nach außerhalb übertragen können. Dies ist bisher lediglich mit elektronischen Schaltungen möglich, welche als starre Platinen ausgebildet sind. Mit anderen Worten werden als Sensoren sowie als Übertragungsschaltungen bisher Chipmodule mit vergossenen elektrischen Bauelementen verwendet. Hierbei besteht die Gefahr, dass die starre Platine in dem Produkt aus flexiblem Material, d.h. in dem flexiblen und vorzugsweise elastischen bzw. elastomeren Produkt, durch dessen mechanische und bzw. oder thermische Verformungen wie z.B. durch Dehnung, Stauchung, Biegung und dergleichen im Betrieb zerstört werden kann. Auch müssen die Platinen bei der Verwendung in elastomeren Produkten deren Vulkanisationsprozess überstehen können.

Die WO 2013/044226 A2 beschreibt einen elastischen Dehnungssensor, der in eine künstliche Haut eingebaut werden kann. Der Dehnungssensor kann die Biegung durch die darunter liegende Stützstruktur der Haut erfassen, um die Bewegung der Stützstruktur zu erkennen und zu verfolgen. Der unidirektionale elastische Dehnungssensor kann gebildet werden, indem zwei oder mehr Kanäle in einem elastischen Substratmaterial mit einer leitfähigen Flüssigkeit gefüllt werden. An den Enden der Kanäle verbindet eine Schleifenöffnung die Kanäle, um einen Serpentinen-Kanal zu bilden. Die Kanäle erstrecken sich entlang der Dehnungsrichtung und die Schleifenabschnitte haben eine ausreichend große Querschnittsfläche in der Richtung quer zur Dehnungsrichtung, so dass der Sensor unidirektional ist. Der Widerstand wird an den Enden des Serpentinen-Kanals gemessen und kann zur Bestimmung der Dehnung des Sensors verwendet werden.

Eine Aufgabe der vorliegenden Erfindung ist es, ein flexibles Produkt der eingangs beschriebenen Art bereit zu stellen, dessen elektronische Bauelemente bzw. dessen elektronische Schaltungen, insbesondere dessen Sensorelemente, ebenfalls möglichst flexibel, d.h. weitestgehend aus einem flexiblen Material, ausgebildet ist. Insbesondere sollen zumindest flexibel, d.h. aus einem flexiblen Material, ausgebildete Leiterbahnen geschaffen werden. Zumindest soll eine Alternative zu bekannten derartigen flexiblen Produkten geschaffen werden.

Die Aufgabe wird erfindungsgemäß durch ein flexibles Produkt mit den Merkmalen des Patentanspruchs 1 sowie durch ein Verfahren mit den Merkmalen des Patentanspruchs 10 gelöst. Vorteilhafte Weiterbildungen sind in den Unteransprüchen beschrieben.

Die vorliegende Erfindung betrifft somit ein flexibles Produkt, vorzugsweise ein elastisches Produkt, besonders vorzugsweise ein elastomeres Produkt. Unter einem Produkt wird ein Gegenstand verstanden, welcher das Ergebnis eines Herstellungsprozesses ist. Das flexible Produkt weist wenigstens eine erste Schicht auf, welche zumindest abschnittsweise, vorzugsweise vollständig, aus einem flexiblen, vorzugsweise aus einem elastischen, besonders vorzugsweise aus einem elastomeren, Material ausgebildet ist. Auch können entsprechende Kunststoffe als flexibles Material verwendet werden.

Die Eigenschaft der Flexibilität des Produkts ist dabei als Materialeigenschaft zu verstehen, welche durch die Verwendung eines flexiblen Materials, vorzugsweise durch die Verwendung eines elastischen Materials und besonders vorzugsweise durch die Verwendung eines elastomeren Materials, vorzugsweise Gummi, erreicht werden kann. Das Produkt kann dabei vollkommen, von den weiteren erfindungsgemäßen Merkmalen abgesehen, aus diesem Material bestehen oder dieses Material zumindest im Wesentlichen aufweisen, so dass die flexible Materialeigenschaft des Produkts erreicht werden kann.

Das flexible Produkt ist erfindungsgemäß durch wenigstens eine Aussparung der ersten Schicht gekennzeichnet, welche zumindest abschnittsweise eine elektrisch leitfähige flexible Füllung aufweist, wobei durch die die elektrisch leitfähige flexible Füllung aufweisende Aussparung wenigstens eine Leiterbahn und bzw. der wenigstens ein elektrisches Bauelement ausgebildet wird. Unter einer Leiterbahn wird dabei eine Leiterbahn einer elektronischen Schaltung verstanden. Unter einem elektrischen Bauelement wird ein sonstiger Bestandteil einer elektronischen Schaltung verstanden. Vorzugsweise ist das elektrische Bauelement bzw. die elektronische Schaltung ein solches, welches bisher als Chipmodule als vergossenes elektrisches Bauelement bzw. als vergossene elektronische Schaltung starr als Platine ausgeführt wird. Das elektrische Bauelement bzw. die elektronische Schaltung kann beispielsweise ein Sensor oder ein Sensorelement wie z.B. ein Messfühler sein. Der Sensor bzw. das Sensorelement kann z.B. kapazitiv und bzw. oder induktiv arbeiten und bzw. oder einen ohmschen Widerstand erfassen können. Beispielsweise können Temperatur-, Kraft-, Druck- und bzw. oder Beschleunigungssensoren ausgebildet werden.

Das elektrische Bauelement bzw. die elektronische Schaltung kann auch ein Aktor oder ein Aktorbestandteil sein. Das elektrische Bauelement bzw. die elektronische Schaltung kann ferner eine Batterie bzw. ein wiederaufladbarer Akkumulator sein. Auch kann das elektrische Bauelement bzw. die elektronische Schaltung eine Verarbeitungselektronik bzw. eine Recheneinheit sein, welche Signale und bzw. oder Daten verarbeiten kann. Ebenso kann das elektrische Bauelement bzw. die elektronische Schaltung eine Signalübertragungseinheit, vorzugsweise eine drahtlose Signalübertragungseinheit mit oder ohne Antenne wie z.B. NFC (Near Field Communication) oder RFID (Radio-Frequency IDentification), sein, welche Signal empfangen und bzw. oder versenden kann. Auch können hierdurch Heiz- und bzw. oder Kühlelemente ausgebildet werden.

Mit anderen Worten liegt der vorliegenden Erfindung die Erkenntnis zugrunde, dass Bestandteile von elektronischen Schaltungen bis hin zu ganzen elektronischen Schaltungen dadurch auf bzw. in Schichten aus einem flexiblen Material wie insbesondere Gummi hergestellt werden können, indem in eine Aussparung einer derartigen Schicht eine elektrisch leifähige flexible Füllung eingebracht wird. Hierdurch kann es ermöglicht werden, dass die elektrisch leitfähige flexible Füllung Bewegungen der ersten Schicht ausreichend folgen kann, ohne beschädigt oder zerstört zu werden, so dass die Funktionalität der elektrisch leifähigen flexiblen Füllung auch bei Verformungen der ersten Schicht erhalten bleiben kann.

Die Aussparung kann dabei vielfältig gestaltet sein. Insbesondere kann die Tiefe der Aussparung und bzw. oder die Breite der Aussparung variieren, so dass unterschiedlich tiefe bzw. breite Abschnitte der elektrisch leifähigen flexiblen Füllung geschaffen werden können. Durch diese Variationen können auch dreidimensionale Aussparungen und damit auch dreidimensional verlaufende elektrisch leifähige flexible Füllungen geschaffen werden. Werden mehrere derartige Schichten miteinander kombiniert, können dreidimensional verlaufende Leiterbahnen bzw. sich dreidimensional erstreckende elektrische Bauelemente bzw. elektronische Schaltungen geschaffen werden.

Vorzugsweise kann die erste Schicht und insbesondere das flexible Produkt als Ganzes ohne die Verwendung von Gewebestrukturen wie z.B. Glasfasergewebe ausgebildet werden. Dies kann die Flexibilität erhöhen bzw. bewahren sowie die Herstellungskosten gering halten.

Gemäß einem Aspekt der vorliegenden Erfindung wurde die Aussparung durch Gravieren, vorzugsweise durch Laser-Gravieren, erzeugt. Hierdurch kann ein erprobtes und definiertes Verfahren genutzt werden, um eine Aussparung in eine derartige Schicht einzubringen. Dies kann einfach, schnell, kostengünstig und bzw. oder vielfältig bzw. variantenreich erfolgen. Auch können unterschiedliche Gravurstärken verwendet werden, welche auch innerhalb einer Aussparung variieren können.

Dies gilt insbesondere für das Gravieren mittels Laser, so dass insbesondere elastomere Material gut graviert werden können. Ferner können Gravuren, welche mittels Laser erzeugt werden, insbesondere in der Tiefe sehr einfach und genau variiert werden.

Vorteilhaft beim Gravieren und insbesondere beim Laser-Gravieren der Aussparung ist, dass dieser Herstellungsschritt vielfältig umgesetzt werden kann. So ist es möglich, die erste Schicht zu positionieren und das Gravurwerkzeug über die erste Schicht zu bewegen. Alternativ kann auch umgekehrt das Gravurwerkzeug feststehend angeordnet sein und die erste Schicht relativ zum Gravurwerkzeug bewegt werden. Auch besteht die Möglichkeit, die erste Schicht kontinuierlich zu bewegen und das Gravurwerkzeug fortlaufend über die sich bewegende erste Schicht zu bewegen und die Aussparung dort einbringen zu lassen. Hierdurch kann ein fortlaufender Herstellungsprozess erfolgen, der über sehr lange Strecken bis hin zu einem endlosen Prozess betrieben werden kann.

Gemäß der vorliegenden Erfindung wurde die Aussparung durch Drucken mit der elektrisch leitfähigen flexiblen Füllung gefüllt. Hierdurch kann dieser Schritt des Herstellungsverfahrens erprobt, einfach und bzw. oder schnell erfolgen. Als Druckverfahren können z.B. Siebdruck oder Flexodruck verwendet werden. Zum Drucken gehört auch das Rakeln.

Gemäß einem weiteren Aspekt der vorliegenden Erfindung weist die elektrisch leitfähige flexible Füllung zumindest abschnittsweise ein metallisches Material, vorzugsweise eine Silberlotpaste, oder ein organisches Material auf, vorzugsweise besteht sie daraus. Hierdurch kann die elektrische Leitfähigkeit bei gleichzeitiger Flexibilität des Materials erreicht werden. Auch können z.B. Tinten als elektrisch leitfähige flexible Füllungen verwendet werden.

Vorzugsweise ist die elektrisch leitfähige flexible Füllung in einem ungesinterten Zustand elektrisch leitfähig, so dass die zuvor beschriebenen Eigenschaften bereits ohne eine entsprechende Wärmebehandlung erreicht werden können, da eine Wärmebehandlung das flexible Produkt verändern könnte. Insbesondere kann das Material der elektrisch leitfähigen flexiblen Füllung wie z.B. eine Tinte elastisch und damit dehnbar bleiben.

Gemäß einem weiteren Aspekt der vorliegenden Erfindung weist die elektrisch leitfähige flexible Füllung zumindest abschnittsweise ein Fluid, vorzugsweise eine Flüssigkeit, besonders vorzugsweise Wasser, auf, vorzugsweise besteht sie daraus. Auf diese Art und Weise können auch Fluide innerhalb der Aussparungen verwendet werden, um die zuvor beschriebenen Eigenschaften zu erreichen. Insbesondere kann Wasser als elektrisch leitfähige flexible Füllung sehr kostengünstig und bzw. oder ungiftig sowie chemisch unkritisch gegenüber dem flexiblen Material der ersten Schicht sein, so dass eine lange Haltbarkeit des flexiblen Produktes erreicht werden kann. Insbesondere können Messungen eines ohmschen Widerstands sehr einfach und kostengünstig über eine Wasser-Füllung umgesetzt werden. Die Flüssigkeit kann auch eine Emulsion sein.

Dabei ist es möglich, wie später noch näher beschrieben werden wird, die Aussparung mit einer zweiten Schicht zu verschließen, um die Flüssigkeit in der Aussparung zu halten. Dies kann dadurch erfolgen, dass die Aussparung der ersten Schicht ausgebildet, die Flüssigkeit eingefüllt und die gefüllte Aussparung anschließend durch die zweite Schicht verschlossen wird. Alternativ kann auch zuerst die Aussparung der ersten Schicht ausgebildet und durch die zweite Schicht bis auf wenigstens eine Öffnung und vorzugsweise zwei Öffnungen verschlossen werden. Durch die eine Öffnung kann dann die Flüssigkeit in den Hohlraum der Aussparung eingefüllt werden, wobei die dort vorhandene Luft über die ggfs. vorhandene zweite Öffnung entweichen kann. Die Öffnung bzw. die Öffnungen kann bzw. können dann verschlossen werden.

Gemäß einem weiteren Aspekt der vorliegenden Erfindung weist die Aussparung der ersten Schicht wenigstens ein elektronisches Bauelement auf. Unter einem elektronischen Bauelement wird eine elektronische Schaltung oder dergleichen in Form z.B. eines Chipmoduls als starres Element bzw. als starre Platine verstanden, wie es bisher aus der Elektronik bekannt ist. Ein derartiges elektronisches Bauelement kann z.B. eine LED, ein Transistor, ein Stecker, eine Batterie bzw. ein Akkumulator, eine integrierte Schaltung, ein Prozessor, ein Speicher, eine Antenne, eine Sender und bzw. oder ein Empfänger und dergleichen sein bzw. dies aufweisen. Hierdurch wird es ermöglicht, bekannte und üblicherweise weit entwickelte sowie kompakt aufgebaute elektronische Schaltungen und dergleichen in das flexible Produkt zu integrieren und mit den erfindungsgemäßen flexiblen Leiterbahnen bzw. flexiblen elektronischen Schaltungen zu kombinieren. Auf diese Art und Weise können sowohl bekannte elektronische Bauelemente als auch die Flexibilität der ersten Schicht genutzt werden.

Gemäß einem weiteren Aspekt der vorliegenden Erfindung weist das flexible Produkt wenigstens eine zweite Schicht auf, welche die Aussparung der ersten Schicht zumindest abschnittsweise, vorzugsweise vollständig, abdeckt. Hierdurch kann die Aussparung begrenzt und abgeschlossen werden, um das Volumen der Aussparung zu definieren. Ferner kann die in der Aussparung aufgenommene elektrisch leitfähige flexible Füllung und bzw. oder das elektronische Bauelement dort gehalten sowie gegenüber äußeren Einflüssen geschützt werden. Dies gilt insbesondere für viskose oder flüssige elektrisch leitfähige flexible Füllungen.

Gemäß einem weiteren Aspekt der vorliegenden Erfindung ist das flexible Produkt ein flexibler Sensor, vorzugsweise ein elastischer Sensor, besonders vorzugsweise ein elastomerer Sensor. Auf diese Art und Weise kann ein Sensor als flexibler Körper ausgebildet werden, um vorzugsweise in bzw. auf anderen flexiblen Körpern wie z.B. einem Reifen, einem Antriebsriemen, einem Förderband, einer Luftfeder oder einem Schlauch verwendet zu werden.

Gemäß einem weiteren Aspekt der vorliegenden Erfindung ist das flexible Produkt ein Reifen, ein Antriebsriemen, ein Förderband, eine Luftfeder oder ein Schlauch. Hierdurch kann eine direkte Integration in das flexible Produkt bereits bei dessen Herstellung erfolgen.

Die vorliegende Erfindung betrifft auch ein Verfahren zur Herstellung eines flexiblen Produkts wie zuvor beschrieben mit wenigstens den Schritten:
- Erzeugen einer Aussparung einer ersten Schicht des flexiblen Produkts, vorzugweise durch Gravieren, vorzugsweise durch Laser-Gravieren, und
- Füllen der Aussparung der ersten Schicht zumindest abschnittsweise mit einer

elektrisch leitfähigen flexiblen Füllung durch Drucken,
wobei durch die die elektrisch leitfähige flexible Füllung aufweisende Aussparung wenigstens eine Leiterbahn und bzw. oder wenigstens ein elektrisches Bauelement ausgebildet wird.

Auf diese Art und Weise kann ein erfindungsgemäßes flexibles Produkt hergestellt werden. Ein Ausführungsbeispiel und weitere Vorteile der Erfindung werden nachstehend im Zusammenhang mit den folgenden Figuren erläutert. Darin zeigt:
- Fig. 1: eine perspektivische schematische Darstellung eines flexiblen Produkts beim Erzeugen einer Aussparung in einer ersten Schicht;
- Fig. 2: die Darstellung der Figur 1 mit gefüllter Aussparung; und
- Fig. 3: die Darstellung der Figur 2 mit einer zweiten Schicht.

Die Beschreibung der o.g. Figuren erfolgt in kartesischen Koordinaten mit einer Längsrichtung X, einer zur Längsrichtung X senkrecht ausgerichteten Querrichtung Y sowie einer sowohl zur Längsrichtung X als auch zur Querrichtung Y senkrecht ausgerichteten vertikalen Richtung Z. Die Längsrichtung X kann auch als Tiefe X, die Querrichtung Y auch als Breite Y und die vertikale Richtung Z auch als Höhe Z bezeichnet werden.

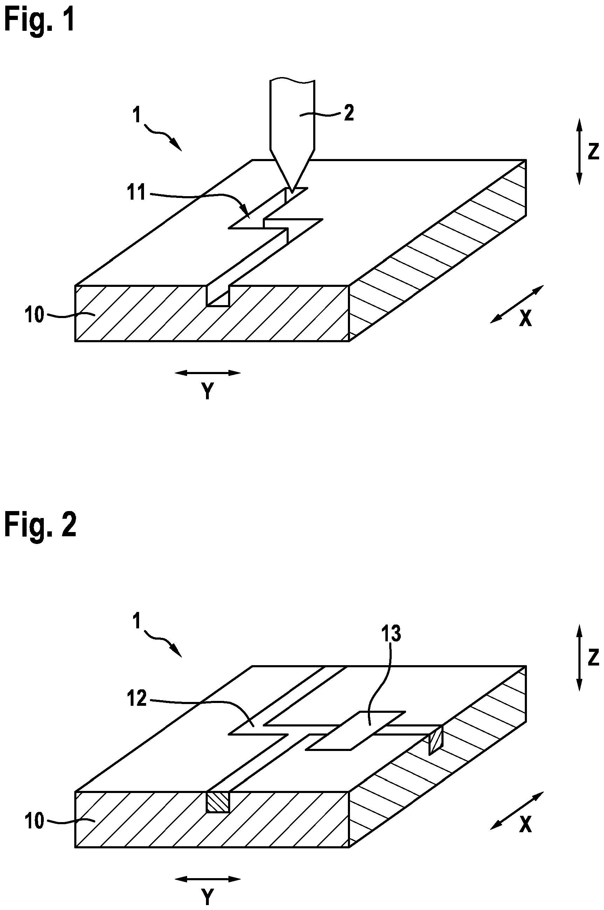

Fig. 1 zeigt eine perspektivische schematische Darstellung eines flexiblen Produkts 1 beim Erzeugen einer Aussparung 11 in einer ersten Schicht 10. Die erste Schicht 10 besteht aus einem elastomeren Material, so dass die erste Schicht 10 flexibel ausgebildet ist. Die erste Schicht 10 erstreckt sich dabei im Wesentlichen in der Ebene der Längsrichtung X und der Querrichtung Y und ist in der Höhe Z vergleichsweise gering, d.h. dünn, ausgebildet.

In der Höhe Z von oben wird in einem ersten Herstellungsschritt mittels eines Gravurwerkzeugs 2 in Form eines Gravur-Lasers 2 eine Aussparung 11 in die Oberfläche der oberen Seite der ersten Schicht 10 eingebracht. Diese Aussparung 11 kann einen beliebigen Verlauf aufweisen, wobei auch Verzweigungen, T-Kreuzungen, Kreuzungen etc. möglich sind. Insbesondere kann die Aussparung 11 in der Breite, d.h. in ihrer Erstreckung in der Längsrichtung X und der Querrichtung Y, sowie in der Tiefe, d.h. in der Höhe Z, variieren. Dieser erste Herstellungsschritt des Gravierens der Oberfläche der oberen Seite der ersten Schicht 10 resultiert in einer Grundstruktur, welche auch als Negativ des folgenden Druckschritts angesehen werden kann, in dem das Verfüllen der Aussparung 11 durch u.a. eine elektrisch leitfähige flexible Füllung 12 erfolgt.

In einem zweiten Schritt wird die Aussparung 11 an einer quadratisch ausgebildeten Stelle durch ein elektronisches Bauelement 13 ausgefüllt, an den sich beidseitig eine elektrisch leitfähige flexible Füllung 12 in Form einer Silberlotpaste anschließt, welche die übrige Aussparung 11 ausfüllt, siehe Figur 2. Auf diese Art und Weise kann das elektronische Bauelement 13 zum einen in ein flexibles Material der ersten Schicht 10 eingebettet und zum anderen mit einer Leiterbahn 12 aus einem anderen flexiblen Material elektrisch leitfähig verbunden werden. Hierdurch wird erfindungsgemäß eine elektronische Schaltung geschaffen, welche als Ganzes weitestgehend flexibel ausgebildet ist und somit die mechanischen Belastungen des flexiblen Produkts 1 besser aufnehmen kann als bisher bekannte starre Platinen.

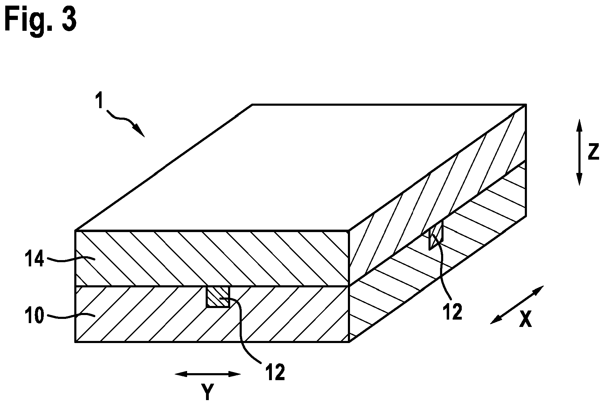

Fig. 3 zeigt die Darstellung der Figur 2 mit einer zweiten Schicht 14, welche aus dem gleichen flexiblen Material der ersten Schicht 10 besteht. Hierdurch kann die Flexibilität der ersten Schicht 10 beibehalten und gleichzeitig das elektronische Bauelement 13 sowie die Leiterbahn 12 innerhalb der Aussparung 11 der ersten Schicht 10 gehalten und gegenüber äußeren Einflüssen geschützt werden.

Anschließend wird das flexible elastomere Produkt 1 vulkanisiert, um seine endgültigen Materialeigenschaften zu erhalten.

### Bezugszeichenliste (Teil der Beschreibung)

- X: Längsrichtung; Tiefe
- Y: Querrichtung; Breite
- Z: vertikale Richtung; Höhe

- 1: flexibles Produkt; elastisches Produkt; elastomeres Produkt; Sensor; Reifen; Antriebsriemen; Förderband; Luftfeder; Schlauch
- 10: erste Schicht
- 11: Aussparung der ersten Schicht 10
- 12: elektrisch leitfähige flexible Füllung der Aussparung 11; Leiterbahn; elektrisches Bauelement
- 13: elektronisches Bauelement
- 14: zweite Schicht

- 2: Gravurwerkzeug; Gravur-Laser

## Patentansprüche

1. Flexibles Produkt (1), vorzugsweise elastisches Produkt (1), besonders vorzugsweise elastomeres Produkt (1), mit
wenigstens einer ersten Schicht (10), welche zumindest abschnittsweise, vorzugsweise vollständig, aus einem flexiblen, vorzugsweise aus einem elastischen, besonders vorzugsweise aus einem elastomeren, Material ausgebildet ist, und mit wenigstens einer Aussparung (11) der ersten Schicht (10), welche zumindest abschnittsweise eine elektrisch leitfähige flexible Füllung (12) aufweist,
wobei durch die die elektrisch leitfähige flexible Füllung (12) aufweisende Aussparung (11) wenigstens eine Leiterbahn (12) und/oder wenigstens ein elektrisches Bauelement (12) ausgebildet wird,
**dadurch gekennzeichnet, dass**
die Aussparung (11) durch Drucken mit der elektrisch leitfähigen flexiblen Füllung (12) gefüllt wurde.

2. Flexibles Produkt (1) nach Anspruch 1, **dadurch gekennzeichnet, dass** die Aussparung (11) durch Gravieren, vorzugsweise durch Laser-Gravieren, erzeugt wurde.

3. Flexibles Produkt (1) nach Anspruch 1 oder 2, **dadurch gekennzeichnet, dass** die elektrisch leitfähige flexible Füllung (12) zumindest abschnittsweise ein metallisches Material, vorzugsweise eine Silberlotpaste, oder ein organisches Material aufweist, vorzugsweise daraus besteht.

4. Flexibles Produkt (1) nach einem der vorherigen Ansprüche, **dadurch gekennzeichnet, dass**
die elektrisch leitfähige flexible Füllung (12) zumindest abschnittsweise ein Fluid, vorzugsweise eine Flüssigkeit, besonders vorzugsweise Wasser, aufweist, vorzugsweise daraus besteht.

5. Flexibles Produkt (1) nach einem der vorherigen Ansprüche, **dadurch gekennzeichnet, dass**
die Aussparung (11) der ersten Schicht (10) wenigstens ein elektronisches Bauelement (13) aufweist.

6. Flexibles Produkt (1) nach einem der vorherigen Ansprüche, **gekennzeichnet durch** wenigstens eine zweite Schicht (14), welche die Aussparung (11) der ersten Schicht (10) zumindest abschnittsweise, vorzugsweise vollständig, abdeckt.

7. Flexibles Produkt (1) nach einem der vorherigen Ansprüche, **dadurch gekennzeichnet, dass**
das flexible Produkt (1) ein flexibler Sensor (1), vorzugsweise ein elastischer Sensor (1), besonders vorzugsweise ein elastomerer Sensor (1), ist.

8. Flexibles Produkt (1) nach einem der Ansprüche 1 bis 6, **dadurch gekennzeichnet, dass**
das flexible Produkt (1) ein Reifen (1), ein Antriebsriemen (1), ein Förderband (1), eine Luftfeder (1) oder ein Schlauch (1) ist.

9. Verfahren zur Herstellung eines flexiblen Produkts (1) nach einem der vorherigen Ansprüche, mit wenigstens den Schritten:
Erzeugen einer Aussparung (11) einer ersten Schicht (10) des flexiblen Produkts (1), vorzugweise durch Gravieren, vorzugsweise durch Laser-Gravieren, und
Füllen der Aussparung (11) der ersten Schicht (10) zumindest abschnittsweise mit einer elektrisch leitfähigen flexiblen Füllung (12) durch Drucken,
wobei durch die die elektrisch leitfähige flexible Füllung (12) aufweisende Aussparung (11) wenigstens eine Leiterbahn (12) und/oder wenigstens ein elektrisches Bauelement (12) ausgebildet wird.

## Claims

1. Flexible product (1), preferably an elastic product (1), particularly preferably an elastomeric product (1), comprising
at least one first layer (10), which is at least partly, preferably completely, formed from a flexible material, preferably from an elastic material, particularly preferably from an elastomeric material, and comprising at least one recess (11) in the first layer (10), which at least partly has an electrically conductive flexible filling (12), wherein at least one conductor track (12) and/or at least one electrical component (12) is/are formed by the recess (11) having the electrically conductive flexible filling (12),
**characterized in that**
the recess (11) was filled with the electrically conductive flexible filling (12) by printing.

2. Flexible product (1) according to Claim 1,
**characterized in that**
the recess (11) was produced by engraving, preferably by laser engraving.

3. Flexible product (1) according to Claim 1 or 2,
**characterized in that**
the electrically conductive flexible filling (12) at least partly comprises a metallic material, preferably a silver solder paste, or an organic material, preferably consists thereof.

4. Flexible product (1) according to one of the preceding claims, **characterized in that**
the electrically conductive flexible filling (12) at least partly comprises a fluid, preferably a liquid, particularly preferably water, preferably consists thereof.

5. Flexible product (1) according to one of the preceding claims, **characterized in that**
the recess (11) in the first layer (10) has at least one electronic component (13).

6. Flexible product (1) according to one of the preceding claims, **characterized by**
at least one second layer (14), which at least partly, preferably completely, covers the recess (11) in the first layer (10).

7. Flexible product (1) according to one of the preceding claims, **characterized in that**
the flexible product (1) is a flexible sensor (1), preferably an elastic sensor (1), particularly preferably an elastomeric sensor (1).

8. Flexible product (1) according to one of Claims 1 to 6, **characterized in that**
the flexible product (1) is a tyre (1), a drive belt (1), a conveyor belt (1), an air spring (1) or a hose (1) .

9. Method for producing a flexible product (1) according to one of the preceding claims, comprising at least the steps of:
producing a recess (11) in a first layer (10) of the flexible product (1), preferably by engraving, preferably by laser engraving, and at least partly filling the recess (11) in the first layer (10) with an electrically conductive flexible filling (12) by printing,
wherein at least one conductor track (12) and/or at least one electrical component (12) is formed by the recess (11) having the electrically conductive flexible filling (12).

## Revendications

1. Produit flexible (1), de préférence produit élastique (1), de manière particulièrement préférée produit élastomère (1), comprenant
au moins une première couche (10), qui est formée au moins en sections, de préférence en totalité, par un matériau flexible, de préférence élastique, de manière particulièrement préférée élastomère, et comprenant au moins un évidement (11) de la première couche (10), qui comprend au moins en sections un remplissage flexible électriquement conducteur (12),
au moins une piste conductrice (12) et/ou au moins un composant électrique (12) étant formé par l'évidement (11) comprenant le remplissage flexible électriquement conducteur (12),
**caractérisé en ce que**
l'évidement (11) a été rempli avec le remplissage flexible électriquement conducteur (12) par impression.

2. Produit flexible (1) selon la revendication 1, **caractérisé en ce que** l'évidement (11) a été généré par gravure, de préférence par gravure laser.

3. Produit flexible (1) selon la revendication 1 ou 2, **caractérisé en ce que** le remplissage flexible électriquement conducteur (12) comprend au moins en sections un matériau métallique, de préférence une pâte d'apport d'argent, ou un matériau organique, de préférence en est constitué.

4. Produit flexible (1) selon l'une quelconque des revendications précédentes, **caractérisé en ce que** le remplissage flexible électriquement conducteur (12) comprend au moins en sections un fluide, de préférence un liquide, de manière particulièrement préférée de l'eau, de préférence en est constitué.

5. Produit flexible (1) selon l'une quelconque des revendications précédentes, **caractérisé en ce que** l'évidement (11) de la première couche (10) comprend au moins un composant électronique (13).

6. Produit flexible (1) selon l'une quelconque des revendications précédentes, **caractérisé par** au moins une deuxième couche (14), qui recouvre au moins en sections, de préférence en totalité, l'évidemment (11) de la première couche (10).

7. Produit flexible (1) selon l'une quelconque des revendications précédentes, **caractérisé en ce que** le produit flexible (1) est un capteur flexible (1), de préférence un capteur élastique (1), de manière particulièrement préférée un capteur élastomère (1).

8. Produit flexible (1) selon l'une quelconque des revendications 1 à 6, **caractérisé en ce que** le produit flexible (1) est un pneu (1), une courroie d'entraînement (1), une bande de transport (1), un ressort pneumatique (1) ou un tuyau (1).

9. Procédé de fabrication d'un produit flexible (1) selon l'une quelconque des revendications précédentes, comprenant les étapes suivantes :
la génération d'un évidement (11) d'une première couche (10) du produit flexible (1), de préférence par gravure, de préférence par gravure laser, et
le remplissage de l'évidement (11) de la première couche (10) au moins en sections avec un remplissage flexible électriquement conducteur (12) par impression,
au moins une piste conductrice (12) et/ou au moins un composant électrique (12) étant formé par l'évidement (11) comprenant le remplissage flexible électriquement conducteur (12).
